# FASCICULE DE BREVET EUROPEEN

(11) **EP 2 864 715 B1**
(45) Date de publication et mention de la délivrance du brevet: **15.03.2017**
(21) Numéro de dépôt: 13719891.7
(22) Date de dépôt: 19.03.2013
(51) Int. Cl.: F24J 2/04, F24J 2/20, F24J 2/50, E06B 3/28, E06B 7/02, H01L 31/054

(54) **CAPTEUR D'ÉNERGIE SOLAIRE TRANSPARENT**
TRANSPARENTER SONNENENERGIEKOLLEKTOR
TRANSPARENT SOLAR ENERGY COLLECTOR

(30) Priorité: 22.03.2012 FR 1200859
(43) Date de publication de la demande: 29.04.2015
(73) Titulaire: Sunpartner Technologies, 13090 Aix-en-Provence (FR)
(72) Inventeur: GILBERT, Joël, F-13510 Eguilles (FR)
(74) Mandataire: Nicolle, Olivier
(86) Numéro de dépôt international: PCT/FR2013/000075
(87) Numéro de publication internationale: WO 2013/140052

(56) Documents cités:
- EP-A2- 1 506 449
- WO-A1-01/57559
- AT-A4- 508 132
- US-A- 5 548 422

## Description

La présente invention se rapporte à un dispositif de capture de l'énergie solaire suivant le préambule de la revendication 1.

### ETAT DE LA TECHNIQUE

Les capteurs d'énergie solaire transforment la lumière solaire en énergie calorifique, électrique ou chimique, ou en une combinaison de ces différentes énergies. Pour cela les capteurs solaires utilisent des matériaux qui absorbent et transforment tout ou partie du rayonnement solaire reçu. Cette absorption dépend du matériau absorbant utilisé et de la longueur d'onde du rayonnement solaire. Idéalement un corps noir peut absorber la majorité du rayonnement solaire et le transformer en calories, ce qui élève la température du capteur.

Les panneaux solaires thermiques qui utilisent ce principe sont d'ordinaire opaques car ils absorbent les longueurs d'ondes qui sont dans le domaine du visible, ainsi que les longueurs d'ondes qui sont dans le domaine de l'Ultra-Violet et de l'Infrarouge.

Or il peut être intéressant dans certaines applications d'utiliser des capteurs solaires qui sont transparents à la lumière visible et qui ne capturent que le rayonnement ultraviolet et/ou Infrarouge du spectre solaire. C'est le cas notamment dans le domaine du bâtiment et de l'agriculture où l'on a besoin d'énergie pour réguler la température des locaux ou des serres tout en ayant également besoin de lumière naturelle à l'intérieur de ces espaces.

Par simplification de langage, on utilisera dans la suite le terme « transparent » pour indiquer que l'élément transparent laisse passer la lumière visible, indépendamment de son comportement dans d'autres gammes de longueur d'onde.

Il existe déjà des vitres transparentes qui ont la propriété de réfléchir le rayonnement Infrarouge, mais ce rayonnement n'est pas capturé à des fins de chauffage, ou bien avec une efficacité assez faible.

Il existe aussi des vitres dites «pariéto dynamiques » qui sont constituées d'un triple vitrage transparent à l'intérieur duquel circule un flux d'air qui s'échauffe par effet de serre, c'est-à-dire que le verre retient une partie du rayonnement Infrarouge qu'il reçoit tout en formant une barrière d'isolation thermique vers l'extérieur. L'air échauffé entre les différentes parois vitrées est pulsé dans le local attenant afin de chauffer celui-ci tout en permettant à la lumière extérieure de traverser les vitres. Mais comme les vitres transparentes ordinaires n'absorbent que peu le rayonnement Infrarouge, l'efficacité de ce dispositif est réduite.

Le document AT 508 132 A4 décrit un dispositif de captue de l'énergie solaire suivant le préambule de la revendication 1.

### BUT DE L'INVENTION

L'invention a pour but principal d'améliorer l'efficacité des capteurs solaires thermiques transparents grâce à un dispositif optique qui va augmenter le taux de capture de l'énergie solaire invisible, principalement celle du rayonnement Infrarouge, tout en conservant pour ledit capteur une bonne transparence à la lumière visible.

Un autre but de l'invention est de proposer un dispositif de capture d'énergie solaire transparent ou semi-transparent et dont le degré de transparence et le degré de capture du rayonnement infrarouge puissent être aisément adaptés par un choix approprié des matériaux utilisés.

Un autre but de l'invention est de proposer un dispositif de capture d'énergie solaire simple et économique, et qui puisse aisément être intégré dans toutes sortes de structures de support afin de rendre le capteur solaire utilisable dans une diversité de contextes applicatifs, qu'il s'agisse notamment du bâtiment, des moyens de transport, ou autres.

### RESUME DE L'INVENTION

Le dispositif selon l'invention est constitué par une ou plusieurs parois vitrées transparentes, encore appelées simplement vitres, qui sont soit séparées par une lame d'air en circulation, soit collées l'une contre l'autre et adjacentes avec une lame d'air avec laquelle elles peuvent assurer un transfert d'énergie thermique.

Chaque vitre ou paroi vitrée comporte deux faces, à savoir une face dite externe et une face dite interne, sachant qu'on définira la face externe comme étant celle exposée à la lumière incidente, notamment la lumière solaire, et la face interne est celle tournée vers la direction opposée.

La première paroi vitrée est celle qui reçoit la lumière solaire extérieure. Selon l'invention, cette première paroi vitrée a subi un traitement optique, en surface ou dans sa matière, de manière à polariser, par exemple circulairement, la lumière qui la traverse. Cette polarisation circulaire peut se faire dans un sens qui, par convention, est soit « Lévogyre » pour un plan de polarisation gauche, soit «Dextrogyre» pour un plan de polarisation droite. Le pouvoir rotatoire de cette première paroi vitrée est du à une structure microscopique dissymétrique incluse sur sa surface ou dans sa matière, comme par exemple un arrangement d'atomes formant une figure géométrique spatiale dissymétrique de molécules ou de cristaux de sorte que ladite figure géométrique ne soit pas superposable avec son image dans un miroir. Ces deux structures microscopiques dissymétriques, images l'une de l'autre mais non superposables, ont la propriété connue de mettre en rotation, en sens opposés, le champ électrique des ondes lumineuses. On définit cette propriété rotatoire par les termes d'activité optique et/ou de biréfringence circulaire. Elle est obtenue à l'aide de certains composés organiques comme les sucres (saccharose, fructose, dextrose).

Des techniques qui permettent de donner cette propriété de biréfringence circulaire à une vitre ou à un film sont déjà connues de l'homme de métier et ne seront pas décrites en détail. On citera simplement une de ces techniques, celle par exemple qui consiste à superposer deux surfaces optiquement actives, la première surface ayant la propriété de polariser la lumière d'une manière linéaire, et l'autre surface ayant la propriété de retarder d'un quart d'onde la composante électrique de l'onde lumineuse.

Selon l'invention, des moyens réfléchissants sont aménagés derrière les moyens de polarisation sur le trajet optique de la lumière incidente. Ces moyens réfléchissants sont par exemple aménagés sur une deuxième paroi vitrée qui a subi elle aussi un traitement optique, en surface ou dans sa matière, de manière à réfléchir le rayonnement Infrarouge incident tout en laissant passer une partie plus ou moins importante de la lumière visible.

De façon connue, le rayonnement Infrarouge polarisé qui est réfléchi par la deuxième vitre va voir son plan de polarisation changer au cours de sa réflexion. C'est en effet une propriété de l'optique ondulatoire qu'une onde électromagnétique dont le plan de polarisation est Dextrogyre devienne Lévogyre, et vice versa, lorsqu'elle est réfléchie par une surface réfléchissante, notamment une surface vitreuse ou une surface métallique. Le rayonnement Infrarouge polarisé réfléchi par la seconde vitre et qui possède donc par exemple un plan de polarisation Lévogyre, se dirige vers la première vitre à polarisation Dextrogyre, qui va alors stopper et absorber ce rayonnement Infrarouge car étant de polarisation inverse.

Or l'absorption des Infrarouges par le filtre polarisant de la vitre exposée va élever sa température et céder ses calories par conduction et par convection à son environnement, et notamment à l'air jouxtant la vitre contenant les moyens de polarisation. L'air ainsi chauffé va alors pouvoir être canalisé pour circuler jusque dans des locaux à chauffer ou à refroidir, le refroidissement pouvant s'effectuer par exemple grâce à des procédés de conversion de l'énergie calorifique bien connus. L'air chaud, ou l'air froid ainsi produit, peut ensuite être éventuellement stocké dans un espace prévu à cet effet.

Le résultat est que le capteur d'énergie solaire selon l'invention peut rester très transparent pour la lumière visible qui le traverse de façon normale, mais il est devenu très opaque pour une grande partie du rayonnement Infrarouge qui a été absorbé par le filtre polarisant. Les Infrarouges ont donc été transformés en énergie calorifique, ce qui a permis l'élévation en température du filtre polarisant, de la vitre qui le porte, et de la lame d'air qui est à son contact.

Le principe de l'invention est aisément adaptable à plusieurs configurations de parois vitrées, par exemple une configuration dans laquelle des moyens polarisants et des moyens réfléchissants sont intégrés à une paroi vitrée unique, ou une configuration dans laquelle les moyens polarisants sont intégrés à une première paroi vitrée, et les moyens réfléchissants sont intégrés à une seconde paroi vitrée.

Dans le cas d'une paroi vitrée unique, celle-ci est entourée par des lames d'air ou d'un autre fluide permettant de récupérer la chaleur formée dans la vitre du fait de l'absorption du rayonnement infrarouge, et ces lames d'air peuvent être délimitées par des vitres transparentes faisant simplement office de double vitrage isolant.

De façon similaire, lorsque deux parois vitrées distinctes sont utilisées, elles peuvent être séparées par une lame d'air ou d'un autre milieu de transfert calorifique disposé entre elles, et éventuellement pourvues vers l'extérieur d'un double vitrage isolant et transparent.

Selon un autre mode de réalisation de l'invention, les deux vitres optiquement traitées pour obtenir des moyens de polarisation et des moyens réfléchissants ne sont pas séparées par une lame d'air, mais directement collées l'une contre l'autre de manière à assurer un contact thermique entre elles, ce qui ne changera rien aux effets optiques successifs de réflexion puis d'absorption du rayonnement infrarouge polarisé, et de l'échauffement de la vitre absorbante qui en résulte. Dans ce cas de figure, une ou plusieurs lames d'air en contact avec la vitre chaude peuvent être reconstruites de part et d'autre des deux vitres collées, par simple délimitation avec une troisième et une quatrième vitre transparente faisant simplement office de double vitrage autour de la structure des deux vitres polarisante et réfléchissante collées.

Le capteur solaire transparent selon l'invention peut également être pourvu sur une partie de sa surface, de moyens de concentration de la lumière solaire incidente, et/ou de moyens de concentration de la lumière visible traversant le capteur.

Le capteur solaire transparent selon l'invention peut encore être pourvu sur une partie de sa surface, de cellules photovoltaïques, transparentes ou non, permettant de générer de l'énergie électrique à partir d'une partie du rayonnement solaire incident, alors que le rayonnement infrarouge est utilisé pour chauffer une paroi vitrée du capteur, en conformité avec le principe de l'invention. Cela permet de générer de la chaleur et de l'électricité à partir d'un même capteur solaire, pourtant au moins partiellement transparent.

De façon détaillée et pour mettre en oeuvre les principes décrits ci-dessus, l'invention a pour objet un dispositif de capture de l'énergie solaire comportant au moins une paroi vitrée transparente ou semi-transparente ayant une face exposée à la lumière incidente du soleil, caractérisé en ce qu'il comporte, sur le trajet des rayons incidents, des moyens de polarisation de la lumière, suivis de moyens réfléchissants aptes à réfléchir vers ladite face exposée tout ou partie de la lumière polarisée et à conférer à celle-ci une polarisation modifiée de façon à ce que la lumière réfléchie soit absorbée par lesdits moyens de polarisation et provoque un échauffement de ladite paroi vitrée.

Selon un mode de réalisation particulier de l'invention, lesdits moyens de polarisation sont choisis pour polariser la lumière incidente d'une manière circulaire (Lévogyre ou Dextrogyre), elliptique ou rectiligne et/ou possèdent une propriété de biréfringence circulaire, et en ce que les moyens réfléchissants sont choisis pour inverser la polarisation de la lumière polarisée transmise par les moyens de polarisation.

Les moyens réfléchissants peuvent être choisis pour ne réfléchir qu'une partie du spectre de longueurs d'ondes lumineuses reçues.

En variante, les moyens réfléchissants peuvent être choisis pour réfléchir uniquement tout ou partie de la composante infrarouge de la lumière polarisée reçue et laisser passer tout ou partie de la composante visible de la lumière polarisée reçue.

Dans un mode de réalisation particulier, les moyens de polarisation de la lumière incidente sont constitués par un filtre polarisant disposé sur la face exposée de la paroi vitrée, ou intégré dans la masse de la paroi vitrée.

Selon l'invention, les moyens réfléchissant la lumière polarisée sont constitués par un filtre réfléchissant apposé sur la face arrière ou non exposée de la paroi vitrée, ou intégré dans la masse de la paroi vitrée.

Selon un premier mode de réalisation, lesdits moyens de polarisation et lesdits moyens réfléchissants sont intégrés à une vitre unique destinée à s'échauffer sous l'effet de l'absorption du rayonnement infrarouge reçu de la part des moyens réfléchissants et qui transmet la chaleur absorbée à au moins une lame d'air délimitée par au moins une vitre transparente.

Selon un autre mode de réalisation, lesdits moyens de polarisation sont intégrés à une première vitre, et lesdits moyens réfléchissants sont intégrés à une seconde vitre placée derrière ladite première vitre sur le trajet des rayons lumineux incidents, ladite première vitre étant amenée à s'échauffer sous l'effet de l'absorption du rayonnement infrarouge reçu de la part des moyens réfléchissants. Dans ce mode de réalisation, la première vitre et la seconde vitre peuvent être séparées par exemple par une lame d'air amenée à s'échauffer au contact de ladite première vitre. Alternativement, la première vitre et la seconde vitre peuvent être fixées ensemble et en contact thermique l'une de l'autre de manière à s'échauffer ensemble sous l'effet de l'absorption du rayonnement infrarouge par ladite première vitre. La chaleur ainsi produite est alors transmise à au moins une lame d'air délimitée d'une part par la première et/ou la seconde vitre et d'autre part par au moins une vitre transparente faisant office de double vitrage isolant.

Dans les différents modes de réalisation envisagés, la vitre unique ou la première vitre et/ou la deuxième vitre est en verre organique ou en verre cristallin.

Selon l'invention, les moyens de polarisation et les moyens réfléchissants sont réalisés par un traitement de surface ou un traitement dans la masse des parois vitrées. En particulier, les moyens réfléchissants peuvent avantageusement être formés à partir de particules métalliques prises parmi l'aluminium, le cuivre, le nickel, le cobalt, le titane, l'argent, l'or et le platine.

Notamment à des fins de protection des personnes, la vitre unique ou la première et/ou la deuxième paroi vitrée réfléchit ou absorbe le rayonnement Ultra-Violet.

L'aspect de la vitre unique ou de la première et/ou de la deuxième paroi vitrée peut varier, ces vitres pouvant être semi transparentes et/ou colorées.

Selon une variante de réalisation facile à mettre en oeuvre, y compris sur des vitrages déjà existants, les moyens de polarisation et/ou les moyens réfléchissants sont intégrés à des films souples et éventuellement autocollants, pouvant être rapportés et fixés sur les vitrages existants afin de transformer ceux-ci en capteurs solaires transparents conformes à l'invention.

Afin de parfaire les transferts de chaleur ou de les adapter aux besoins applicatifs, la lame d'air jouxtant les parois vitrées peut être remplacée par un autre fluide transparent gazeux, liquide ou solide, ou par un corps à changement de phase, ou par du vide.

Avantageusement, le dispositif selon l'invention comporte en outre une optique de type miroir concave, lentille, prisme, lentille de Fresnel ou Héliostat, pour concentrer la lumière solaire incidente vers la face du dispositif exposée à la lumière solaire incidente, et/ou pour concentrer la lumière transmise par le dispositif.

En outre, afin de combiner la transformation d'énergie solaire en chaleur, avec une génération de courant électrique, une variante du dispositif selon l'invention comporte des cellules photovoltaïques disposées sur une partie de la surface des parois vitrées et/ou des vitres transparentes. Ainsi, une partie du rayonnement solaire incident ou du rayonnement transmis éclaire lesdites cellules et est transformée en électricité, alors qu'une autre partie du rayonnement solaire incident est transformée en chaleur.

Dans un mode de réalisation particulier, les cellules photovoltaïques qui assurent la production d'électricité ont également la propriété de polariser la lumière d'une manière rectiligne. Ces cellules photovoltaïques sont alors disposées en micro bandes parallèles espacées par des bandes de transparence dont la largeur est inférieure à 1 micron. Un film quart d'onde placé derrière le polariseur photovoltaïque provoquera alors la transformation de la lumière polarisée linéairement en une lumière polarisée circulairement tout en produisant de l'électricité.

Le dispositif selon l'invention est de préférence équipé d'un système mécanique pour assurer la circulation des fluides gazeux ou liquides entre et/ou autour des parois vitrées, ce qui permet de transporter la chaleur générée vers des locaux ou d'autres endroits où elle est susceptible d'être utilisée.

L'invention a également pour objet un dispositif de capture de l'énergie solaire tel que défini ci-dessus, comportant en outre un cadre ou support métallique, en bois ou en matériaux composites, solide ou souple, apte à adapter le dispositif de capture sur des fenêtres, baies coulissantes, parois de serre, couvertures de piscine, abris de jardin, hublots d'aéronefs, fenêtres de toit, fenêtres de véhicules de transport, affiches publicitaires, vitrines de magasin, tuiles, toitures, et sur tous dispositifs utilisant des matériaux transparents dans les domaines du bâtiment, des véhicules de transport, de l'affichage et de la diffusion d'images, y compris les écrans d'affichage électronique.

### DESCRIPTION DETAILLEE DE L'INVENTION

L'invention est maintenant décrite plus en détails à l'aide de la description des figures.
La figure 1 est un schéma en élévation et en coupe transversale d'un mode de réalisation du capteur d'énergie solaire selon l'invention, montrant le principe de la structure utilisant deux parois vitrées, et son fonctionnement optique.
La figure 2A est un schéma de principe d'une variante de réalisation dans laquelle les deux parois vitrées sont collées ensemble et entourées d'un double vitrage isolant.
La figure 2B est un schéma de principe d'une variante de réalisation dans laquelle les deux parois vitrées sont remplacées par une vitre unique.
La figure 3 est une vue en perspective d'un exemple de réalisation d'une fenêtre d'habitation qui inclut un capteur d'énergie solaire selon la figure 1.
La figure 4 est un graphe représentant les taux de transmission et de réflexion de lumière d'un filtre polarisant circulaire utilisable comme moyen de polarisation dans le cadre du dispositif selon l'invention.

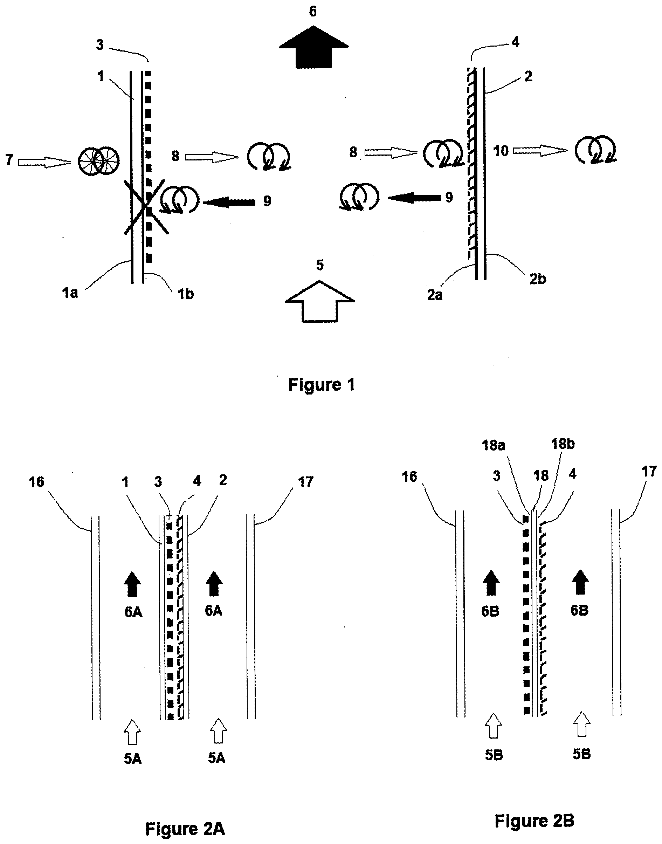

Le dispositif selon la figure 1 est constitué principalement de deux vitres ou parois vitrées (1,2) transparentes séparées par ou jouxtant une lame d'air (5,6) en circulation. La première paroi vitrée (1) reçoit sur sa face externe (1a), ou face exposée, la lumière solaire incidente (7).

Cette première paroi vitrée (1) a préalablement subi un traitement optique (3), en surface ou dans sa matière, pour réaliser des moyens de polarisation ayant pour effet de polariser, par exemple circulairement, la lumière incidente (7) qui la traverse (8). Cette polarisation circulaire peut se faire dans un sens qui, par convention, est soit «Lévogyre» pour un plan de polarisation gauche, soit «Dextrogyre» pour un plan de polarisation droite.

La deuxième paroi vitrée (2) a subi elle aussi un traitement optique (4), en surface ou dans sa matière, pour réaliser des moyens réfléchissants ayant pour effet de réfléchir le rayonnement lumineux polarisé (8), ou une partie de ce rayonnement, par exemple sa composante infrarouge, vers la première paroi vitrée, tout en laissant passer une autre partie du rayonnement lumineux, par exemple l'essentiel de la lumière visible (10), à travers la vitre (2). De ce fait le dispositif peut rester transparent à la lumière visible, mais absorbe la composante infrarouge de la lumière.

En effet, le rayonnement Infrarouge polarisé qui est réfléchi (9) par la deuxième vitre (2), a changé son plan de polarisation au cours de sa réflexion. Ainsi, le plan de polarisation, par exemple Dextrogyre, de la lumière polarisée (8), devient Lévogyre dans le rayonnement infrarouge réfléchi (9). Le rayonnement Infrarouge (9) qui possède maintenant un plan de polarisation Lévogyre se dirige vers la première vitre (1) à polarisation Dextrogyre, qui va alors stopper et absorber ce rayonnement Infrarouge réfléchi (9) car étant de polarisation inverse. L'absorption des Infrarouges réfléchis (9) par le filtre polarisant (3) de la première vitre (1) va donc élever la température du filtre polarisant et de la vitre (1) qui le supporte. Cette vitre (1) va alors céder ses calories à l'air froid (5) contenu entre les deux vitres (1,2). L'air froid (5) se réchauffe donc, et l'air (6) ainsi chauffé qui a circulé entre les deux vitres (1,2) est dirigé ensuite vers les endroits à chauffer, soit par convection, soit de préférence par des moyens de circulation forcée.

La figure 2A illustre un autre mode de réalisation de l'invention, dans lequel les deux parois vitrées (1,2) optiquement activées par les traitements polarisants et réfléchissants (3,4) sont collées l'une contre l'autre de manière à être en contact thermique. Elles sont en outre isolées de l'extérieur par deux vitres transparentes (16,17) disposées de part et d'autre des deux vitres (1,2) collées et faisant office de vitrage isolant. Les espaces situés entre les deux vitres transparentes (16,17) et les deux parois vitrées (1,2) sont parcourus par une lame d'air (5) qui s'échauffe (6) au contact du capteur solaire semi-transparent objet de l'invention.

La figure 2B illustre un mode de réalisation encore plus simple, dans lequel les deux parois vitrées (1,2) sont remplacées par une vitre unique (18) intégrant à la fois les moyens polarisants (3) et les moyens réfléchissants (4), par exemple sous la forme d'un filtre polarisant (3) placé sur la vitre du côté de la lumière solaire incidente, et d'un miroir (4) placé derrière le filtre polarisant sur le trajet optique de la lumière incidente. Comme dans la variante de la figure 2A, la vitre unique (18) pourvue de ses moyens polarisants (3) et réfléchissants (4) est isolée thermiquement de l'environnement par des lames d'air (5B,6B) délimitées et canalisées par des vitrages d'isolation (16,17) transparents.

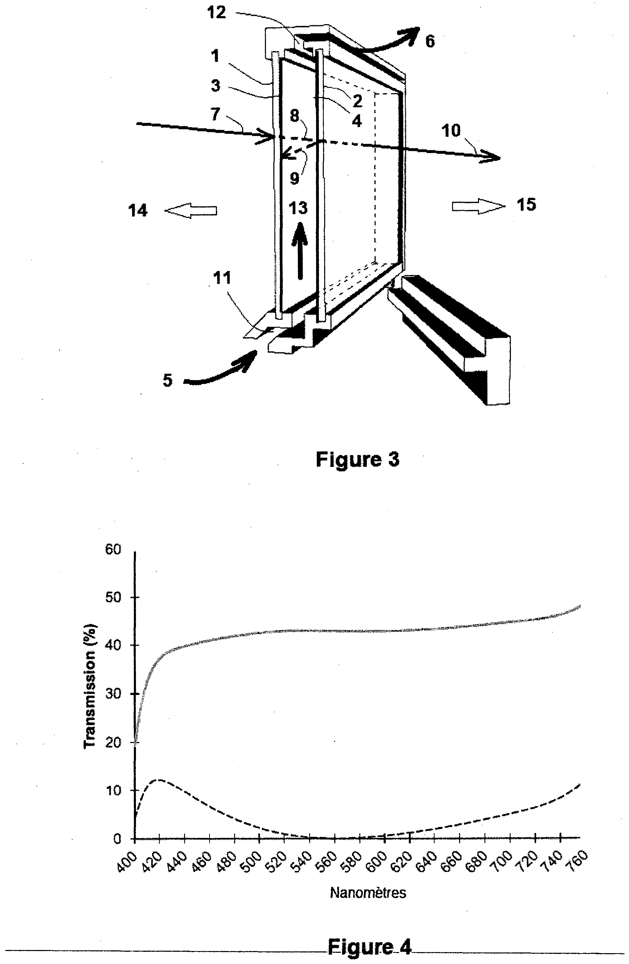

La figure 3 est un exemple concret de réalisation de la variante du dispositif selon la figure 1, appliqué à la réalisation de fenêtres pour habitations. La fenêtre est composée d'un double vitrage (1,2) maintenu par un châssis en bois ou en un autre matériau isolant qui contient des ouvertures (11,12) qui permettent la circulation de l'air extérieur (5) vers l'air intérieur (6) de l'habitation avec une circulation de l'air (13) entre les deux parois vitrées (1,2). L'ouverture vers l'extérieur (11) est de préférence en position basse alors que l'ouverture vers l'intérieur (12) est de préférence en position haute (12) de manière à créer une circulation d'air naturelle de l'extérieur (14) vers l'intérieur (15) de l'habitat. La première paroi vitrée (1) est faite de verre clair de 4 mm d'épaisseur et est recouverte sur sa face intérieure d'un film semi transparent (3) de 100 microns d'épaisseur qui polarise circulairement la lumière entrante (7) dans un sens Dextrogyre, par exemple. La deuxième paroi vitrée (2) est faite d'un verre clair de 4 mm d'épaisseur et est recouverte sur sa face intérieure d'un film semi transparent (4) qui a la propriété de réfléchir le rayonnement solaire Infrarouge, principalement celui dont les longueurs d'ondes sont comprises entre 0,76 et 2,5 microns. Les propriétés de ce film (4), sans que ces valeurs ne soient restrictives quant à l'étendue des caractéristiques du dispositif, sont les suivantes :
Rejet U.V. : 99 %
Réflexion lumière visible (effet miroir) : 7 %
Transmission Lumière Visible : 70 %
Énergie solaire totale rejetée (chaleur) : 49%
Ratio solaire de Réflexion : 27 %
Ratio solaire d'Absorption : 26 %
Ratio solaire de Transmission : 47 %
Réduction d'éblouissement : 20 %
Rejet Infrarouge (760 à 2500 mm) : ∼ 70%
Epaisseur : 50 microns

La distance entre les deux parois vitrées (1,2) est de 28 mm. Les autres dimensions de la fenêtre sont, dans cet exemple :
Hauteur : 1,90 m
Largeur : 0,85 m
Epaisseur totale du double vitrage : 36 mm

On a représenté en figure 4 le taux de transmission d'un filtre polarisant circulaire qui peut être utilisé pour la mise en oeuvre des moyens de polarisation du dispositif selon l'invention.

La courbe supérieure représente, en fonction de la longueur d'onde, le taux de transmission de la lumière incidente (7), après passage dans le filtre polarisant.

La courbe inférieure représente le taux de transmission vers l'extérieur du rayonnement polarisé (9) après réflexion par les moyens réfléchissants.

Comme on le constate sur la courbe inférieure, le taux de transmission vers l'extérieur est compris entre 0 et 10 % en fonction des longueurs d'ondes dans le domaine visible. Bien entendu, l'utilisation d'un filtre polarisant ayant des taux de transmission également très faibles voire voisins de zéro dans le domaine infrarouge permettra encore mieux de piéger le rayonnement infrarouge à l'intérieur du dispositif, ce qui permet de chauffer la paroi vitrée (1 ;18) du dispositif comme décrit précédemment.

Le fonctionnement optique du dispositif selon la figure 3 est alors le suivant. La lumière extérieure (7) incidente devient polarisée (8) en traversant la première vitre (1) et son film polarisant (3). Un taux de 70% du rayonnement Infrarouge de cette lumière polarisée (8) est réfléchi (9) par le film (4) de la deuxième vitre (2) tout en inversant son sens de polarité qui devient donc Lévogyre. Par ailleurs un taux de 70% de la lumière visible (10) traverse la deuxième vitre (2) et entre dans l'habitat. Le rayonnement réfléchi par le film Infrarouge (4) représente 49% de l'énergie solaire reçue, soit si on tient compte des pertes dues à la réflexion vers l'extérieur (14) du rayonnement incident (7), c'est environ 40% de l'énergie reçue globalement par la fenêtre qui est réfléchie par le film Infrarouge (4) vers la lame d'air (5) entre les deux vitres (1,2), ce qui représente l'équivalent d'une puissance de 400 W/m2 lorsque la fenêtre est exposée en plein soleil. Cette énergie est ensuite absorbée par le filtre polarisant (3) de la première vitre (1) qui est opaque pour les rayonnements polarisés Lévogyre (9) comme c'est le cas pour ceux qui sont issus de la réflexion sur le film Infrarouge (4). Sous l'effet de cette absorption, le film polarisant (3) s'échauffe alors jusqu'à atteindre des températures supérieures à 60°C et cède ses calories à l'air (13) avec lequel il est en contact et qui circule entre les deux parois (1,2). L'air chaud (6) est dans cet exemple injecté directement dans le local (15) adjacent à la fenêtre via l'ouverture haute (12) de celle-ci.

Dans un mode de réalisation différent (non représenté), l'air chaud (6) est récupéré par un climatiseur à adsorption afin de refroidir le local (15).

Au total le dispositif selon l'invention permet de capturer près de 40% de l'énergie solaire tout en laissant passer 70% de la lumière visible. Par comparaison, les dispositifs classiques de type pariéto-dynamique qui n'utilisent que du double vitrage (1,2) ou triple vitrage et éventuellement un film Infrarouge (4) de même qualité, mais sans le filtre polarisant (3) qui caractérise cette invention, ne capturent que 10% du rayonnement solaire.

Le dispositif selon l'invention est particulièrement adapté à la capture de l'énergie solaire grâce à des parois vitrées en grande partie transparentes à la lumière visible.

### AVANTAGES DE L'INVENTION

En définitive l'invention permet de capturer bien d'avantage d'énergie solaire qu'un double ou triple vitrage classique tout en conservant une bonne transparence à la lumière visible.

## Revendications

1. Dispositif de capture de l'énergie solaire comportant au moins une paroi vitrée (1,2 ;18) transparente ou semi-transparente ayant une face (1a ;18a) exposée à la lumière incidente (7) du soleil, **caractérisé en ce qu'**il comporte, sur le trajet des rayons incidents, des moyens de polarisation (3) de la lumière, suivis de moyens réfléchissants (4) aptes à réfléchir vers ladite face exposée (1a ;18a) tout ou partie de la lumière polarisée (8) et à conférer à celle-ci une polarisation modifiée de façon à ce que la lumière réfléchie (9) soit absorbée par lesdits moyens de polarisation (3) et provoque un échauffement de ladite paroi vitrée (1 ;18).

2. Dispositif selon la revendication 1, **caractérisé en ce que** lesdits moyens de polarisation (3) sont choisis pour polariser la lumière incidente (7) d'une manière circulaire (Lévogyre ou Dextrogyre), elliptique ou rectiligne et/ou possèdent une propriété de biréfringence circulaire, et **en ce que** les moyens réfléchissants (4) sont choisis pour inverser la polarisation de la lumière polarisée (8) transmise par les moyens de polarisation (3).

3. Dispositif selon la revendication 1 ou la revendication 2, **caractérisé en ce que** les moyens réfléchissants (4) sont choisis pour ne réfléchir qu'une partie du spectre de longueurs d'ondes lumineuses reçues.

4. Dispositif selon la revendication 3, **caractérisé en ce que** lesdits moyens réfléchissants (4) sont choisis pour réfléchir uniquement tout ou partie de la composante infrarouge de la lumière polarisée reçue et laisser passer tout ou partie (10) de la composante visible de la lumière polarisée reçue.

5. Dispositif selon l'une quelconque des revendications précédentes, **caractérisé en ce que** les moyens de polarisation (3) de la lumière incidente (7) sont constitués par un filtre polarisant disposé sur la face exposée (18 a) de la paroi vitrée (18), ou intégré dans la masse de la paroi vitrée (18).

6. Dispositif selon l'une quelconque des revendications précédentes, **caractérisé en ce que** les moyens (4) réfléchissant la lumière polarisée (8) sont constitués par un filtre réfléchissant apposé sur la face arrière (18b) de la paroi vitrée (18), ou intégré dans la masse de la paroi vitrée (18).

7. Dispositif selon l'une quelconque des revendications précédentes, **caractérisé en ce que** lesdits moyens de polarisation (3) et lesdits moyens réfléchissants (4) sont intégrés à une vitre unique (18) destinée à s'échauffer sous l'effet de l'absorption du rayonnement infrarouge reçu de la part des moyens réfléchissants (4) et qui transmet la chaleur absorbée à au moins une lame d'air (5B,6B) délimitée par au moins une vitre transparente (16,17).

8. Dispositif selon l'une quelconque des revendications 1 à 6, **caractérisé en ce que** lesdits moyens de polarisation (3) sont intégrés à une première vitre (1), et **en ce que** lesdits moyens réfléchissants (4) sont intégrés à une seconde vitre (2) placée derrière ladite première vitre (1) sur le trajet des rayons lumineux incidents, ladite première vitre (1) étant amenée à s'échauffer sous l'effet de l'absorption du rayonnement infrarouge reçu de la part des moyens réfléchissants (4).

9. Dispositif selon la revendication 8, **caractérisé en ce que** ladite première vitre (1) et ladite seconde vitre (2) sont séparées par une lame d'air (5,6) amenée à s'échauffer au contact de ladite première vitre (1).

10. Dispositif selon la revendication 8, **caractérisé en ce que** ladite première vitre (1) et ladite seconde vitre (2) sont fixées ensemble et en contact thermique l'une de l'autre de manière à s'échauffer ensemble sous l'effet de l'absorption du rayonnement infrarouge par ladite première vitre (1), et **en ce que** la chaleur ainsi produite est transmise à au moins une lame d'air (5A, 6A) délimitée d'une part par la première et/ou la seconde vitre (1,2) et d'autre part par au moins une vitre transparente (16,17).

11. Dispositif selon l'une quelconque des revendications précédentes, **caractérisé en ce que** la vitre unique (18) ou la première vitre (1) et/ou la deuxième vitre (2) est en verre organique ou en verre cristallin.

12. Dispositif selon l'une quelconque des revendications précédentes, **caractérisé en ce que** lesdits moyens de polarisation (3) et lesdits moyens réfléchissants (4) sont réalisés par un traitement de surface ou un traitement dans la masse des parois vitrées (1,2 ;18).

13. Dispositif selon l'une quelconque des revendications précédentes, **caractérisé en ce que** les moyens réfléchissants (4) sont formés à partir de particules métalliques prises parmi l'aluminium, le cuivre, le nickel, le cobalt, le titane, l'argent, l'or et le platine.

14. Dispositif selon l'une quelconque des revendications précédentes, **caractérisé en ce que** la vitre unique (18) ou la première (1) et/ou la deuxième (2) paroi vitrée (2) réfléchit ou absorbe le rayonnement Ultra-Violet.

15. Dispositif selon l'une quelconque des revendications précédentes, **caractérisé en ce que** la vitre unique (18) ou la première (1) et/ou la deuxième (2) paroi vitrée (2) est semi transparente et/ou colorée.

16. Dispositif selon l'une quelconque des revendications précédentes, **caractérisé en ce que** lesdits moyens de polarisation (3) et/ou lesdits moyens réfléchissants (4) sont intégrés à des films souples et éventuellement autocollants.

17. Dispositif selon l'une quelconque des revendications précédentes, **caractérisé en ce que** la lame d'air (5, 6 ; 5A, 6A) jouxtant les parois vitrées (18 ; 1,2) est remplacée par un autre fluide transparent gazeux, liquide ou solide, ou par un corps à changement de phase, ou par du vide.

18. Dispositif selon l'une quelconque des revendications précédentes, **caractérisé en ce qu'**il comporte une optique de type miroir concave, lentille, prisme, lentille de Fresnel ou Héliostat, pour concentrer la lumière solaire incidente (7) vers la face exposée (1a ; 18a) du dispositif, ou pour concentrer la lumière transmise (10) par le dispositif.

19. Dispositif selon l'une quelconque des revendications précédentes, **caractérisé en ce qu'**il comporte des cellules photovoltaïques disposées sur une partie de la surface des parois vitrées (18 ; 1, 2) et/ou des vitres transparentes (16, 17) de sorte qu'une partie du rayonnement solaire incident (7) ou du rayonnement transmis (10) éclaire lesdites cellules et soit transformé en électricité, alors qu'une autre partie du rayonnement solaire incident (7) est transformé en chaleur.

20. Dispositif selon la revendication 19, **caractérisé en ce que** lesdites cellules photovoltaïques sont disposées en bandes parallèles espacées par des bandes de transparence dont la largeur est inférieure à 1 micron, de sorte que lesdites cellules photovoltaïques assurent à la fois la fonction de polarisation rectiligne du rayonnement solaire incident et la fonction de production d'électricité.

21. Dispositif selon l'une quelconque des revendications précédentes, **caractérisé en ce qu'**il est équipé d'un système mécanique pour assurer la circulation des fluides gazeux ou liquides entre et/ou autour des parois vitrées (18 ; 1,2).

22. Dispositif de capture de l'énergie solaire selon l'une quelconque des revendications précédentes, **caractérisé en ce qu'**il comporte un cadre ou support métallique, en bois ou en matériaux composites, solide ou souple, apte à adapter le dispositif de capture sur des fenêtres, baies coulissantes, parois de serre, couvertures de piscine, abris de jardin, hublots d'aéronefs, fenêtres de toit, fenêtres de véhicules de transport, affiches publicitaires, vitrines de magasin, tuiles, toitures, et sur tous dispositifs utilisant des matériaux transparents dans les domaines du bâtiment, des véhicules de transport, de l'affichage et de la diffusion d'images, y compris les écrans d'affichage électronique.

## Patentansprüche

1. Sonnenenergie-Kollektorvorrichtung, umfassend mindestens eine transparente oder semitransparente Glaswand (1, 2; 18) mit einer Fläche (1a; 18a), die für einfallendes Sonnenlicht (7) freiliegt, **dadurch gekennzeichnet, dass** diese, in der Bahn der einfallenden Strahlen, Polarisationsmittel (3) des Lichts umfasst, gefolgt von Reflexionsmitteln (4), die geeignet sind, das gesamte oder einen Teil des polarisierten Lichts (8) zu der freiliegenden Fläche (1a; 18a) zu reflektieren und diesem eine modifizierte Polarisation zu verleihen, damit das reflektierte Licht (9) von den Polarisationsmitteln (3) absorbiert wird und eine Erwärmung der Glaswand (1; 18) bewirkt.

2. Vorrichtung nach Anspruch 1, **dadurch gekennzeichnet, dass** die Polarisationsmittel (3) ausgewählt sind, das einfallende Licht (7) zirkular (linksdrehend oder rechtsdrehend), elliptisch oder geradlinig und/oder mit einer zirkularen Doppelbrechungseigenschaft zu polarisieren, und dass die Reflexionsmittel (4) ausgewählt sind, die Polarisation des polarisierten Lichts (8), das von den Polarisationsmitteln (3) übertragen wird, zu invertieren.

3. Vorrichtung nach Anspruch 1 oder Anspruch 2, **dadurch gekennzeichnet, dass** die Reflexionsmittel (4) ausgewählt sind, nur einen Teil des Spektrums von empfangenen Lichtwellenlängen zu reflektieren.

4. Vorrichtung nach Anspruch 3, **dadurch gekennzeichnet, dass** die Reflexionsmittel (4) ausgewählt sind, nur die gesamte oder einen Teil der Infrarotkomponente des empfangenen polarisierten Lichts zu reflektieren und die gesamte oder einen Teil (10) der sichtbaren Komponente des empfangenen polarisierten Lichts durchzulassen.

5. Vorrichtung nach einem der vorhergehenden Ansprüche, **dadurch gekennzeichnet, dass** die Polarisationsmittel (3) des einfallenden Lichts (7) aus einem Polarisationsfilter bestehen, das auf der freiliegenden Fläche (18a) der Glaswand (18) angeordnet oder in die Masse der Glaswand (18) integriert ist.

6. Vorrichtung nach einem der vorhergehenden Ansprüche, **dadurch gekennzeichnet, dass** die Mittel (4), die das polarisierte Licht (8) reflektieren, aus einem Reflexionsfilter bestehen, das an der hinteren Fläche (18b) der Glaswand (18) angebracht oder in die Masse der Glaswand (18) integriert ist.

7. Vorrichtung nach einem der vorhergehenden Ansprüche, **dadurch gekennzeichnet, dass** die Polarisationsmittel (3) und die Reflexionsmittel (4) in einer einzigen Glasscheibe (18) integriert sind, welche dazu bestimmt ist, sich unter der Wirkung der Absorption der Infrarotstrahlung zu erwärmen, die von den Reflexionsmitteln (4) empfangenen wird, und welche die absorbierte Wärme zu mindestens einem Luftspalt (5B, 6B) überträgt, der durch mindestens eine transparente Glasscheibe (16, 17) begrenzt wird.

8. Vorrichtung nach einem der Ansprüche 1 bis 6, **dadurch gekennzeichnet, dass** die Polarisationsmittel (3) in einer ersten Glasscheibe (1) integriert sind, und dass die Reflexionsmittel (4) in einer zweiten Glasscheibe (2) integriert sind, die hinter der ersten Glasscheibe (1) in der Bahn einfallender Lichtstrahlen platziert ist, wobei die erste Glasscheibe (1) dazu gebracht wird, sich unter der Wirkung der Absorption der Infrarotstrahlung zu erwärmen, die von den Reflexionsmitteln (4) empfangenen wird.

9. Vorrichtung nach Anspruch 8, **dadurch gekennzeichnet, dass** die erste Glasscheibe (1) und die zweite Glasscheibe (2) durch einen Luftspalt (5, 6) getrennt sind, der dazu gebracht wird, sich in Kontakt mit der ersten Glasscheibe (1) zu erwärmen.

10. Vorrichtung nach Anspruch 8, **dadurch gekennzeichnet, dass** die erste Glasscheibe (1) und die zweite Glasscheibe (2) gemeinsam und in Wärmekontakt miteinander befestigt sind, um sich gemeinsam unter der Wirkung der Absorption der Infrarotstrahlung durch die erste Glasscheibe (1) zu erwärmen, und dass die so erzeugte Wärme zu mindestens einem Luftspalt (5A, 6A) übertragen wird, der einerseits von der ersten und/oder der zweiten Glasscheibe (1, 2) und andererseits von mindestens einer transparenten Glasscheibe (16, 17) begrenzt wird.

11. Vorrichtung nach einem der vorhergehenden Ansprüche, **dadurch gekennzeichnet, dass** die einzige Glasscheibe (18) oder die erste Glasscheibe (1) und/oder die zweite Glasscheibe (2) aus organischem Glas oder kristallinem Glas bestehen.

12. Vorrichtung nach einem der vorhergehenden Ansprüche, **dadurch gekennzeichnet, dass** die Polarisationsmittel (3) und die Reflexionsmittel (4) durch eine Oberflächenbehandlung oder eine Behandlung in der Masse der Glaswände (1, 2; 18) hergestellt sind.

13. Vorrichtung nach einem der vorhergehenden Ansprüche, **dadurch gekennzeichnet, dass** die Reflexionsmittel (4) aus metallischen Teilchen gebildet sind, ausgewählt aus Aluminium, Kupfer, Nickel, Kobalt, Titan, Silber, Gold und Platin.

14. Vorrichtung nach einem der vorhergehenden Ansprüche, **dadurch gekennzeichnet, dass** die einzige Glasscheibe (18) oder die erste (1) und/oder die zweite Glasscheibe (2) Ultraviolettstrahlen reflektieren oder absorbieren.

15. Vorrichtung nach einem der vorhergehenden Ansprüche, **dadurch gekennzeichnet, dass** die einzige Glasscheibe (18) oder die erste (1) und/oder die zweite Glasscheibe (2) semitransparent und/oder gefärbt sind.

16. Vorrichtung nach einem der vorhergehenden Ansprüche, **dadurch gekennzeichnet, dass** die Polarisationsmittel (3) und/oder die Reflexionsmittel (4) in flexiblen und gegebenenfalls selbstklebenden Filmen integriert sind.

17. Vorrichtung nach einem der vorhergehenden Ansprüche, **dadurch gekennzeichnet, dass** der Luftspalt (5, 6; 5A, 6A), der an die Glaswände (18; 1, 2) angrenzt, durch ein anderes gasförmiges, flüssiges oder festes transparentes Fluid oder durch einen Phasenänderungskörper oder durch ein Vakuum ersetzt ist.

18. Vorrichtung nach einem der vorhergehenden Ansprüche, **dadurch gekennzeichnet, dass** diese eine Optik vom Typ eines Konkavspiegels, einer Linse, eines Prismas, einer Fresnel- oder Heliostat-Linse umfasst, um das einfallende Sonnenlicht (7) auf die freiliegende Fläche (1a; 18a) der Vorrichtung zu konzentrieren, oder um das von der Vorrichtung übertragene Licht (10) zu konzentrieren.

19. Vorrichtung nach einem der vorhergehenden Ansprüche, **dadurch gekennzeichnet, dass** diese Photovoltaikzellen umfasst, die auf einem Teil der Fläche der Glaswände (18; 1, 2) und/oder der transparenten Glasscheiben (16, 17) derart angeordnet sind, dass ein Teil der einfallenden Sonnenstrahlung (7) oder der übertragenen Strahlung (10) die Zellen beleuchtet und in Elektrizität umgewandelt wird, während ein anderer Teil der einfallenden Sonnenstrahlung (7) in Wärme umgewandelt wird.

20. Vorrichtung nach Anspruch 19, **dadurch gekennzeichnet, dass** die Photovoltaikzellen in parallelen Bändern angeordnet sind, die durch transparente Bänder beabstandet sind, deren Breite weniger als 1 Mikron beträgt, so dass die Photovoltaikzellen gleichzeitig die Funktion der geradlinigen Polarisation der einfallenden Sonnenstrahlung und die Funktion der Erzeugung von Elektrizität gewährleisten.

21. Vorrichtung nach einem der vorhergehenden Ansprüche, **dadurch gekennzeichnet, dass** diese mit einem mechanischen System ausgestattet ist, um die Zirkulation gasförmiger oder flüssiger Fluide zwischen und/oder rund um die Glaswände (18; 1, 2) zu gewährleisten.

22. Sonnenenergie-Kollektorvorrichtung nach einem der vorhergehenden Ansprüche, **dadurch gekennzeichnet, dass** diese einen festen oder flexiblen Rahmen oder Träger aus Metall, aus Holz oder aus Verbundmaterialien umfasst, der geeignet ist, die Kollektorvorrichtung an Fenster, gleitende Öffnungen, Gewächshauswände, Schwimmbadabdeckungen, Gartenhäuser, Flugzeugfenster, Dachfenster, Transportfahrzeugfenster, Werbe-Displays, Geschäftsvitrinen, Dachziegel, Dächer und an alle Vorrichtungen, die transparente Materialien verwenden, auf den Gebieten von Gebäuden, Transportfahrzeugen, dem Display und der Verbreitung von Bildern, einschließlich Bildschirme für ein elektronisches Display, anzupassen.

## Claims

1. Device for collecting solar energy comprising at least one transparent or semi-transparent glazed wall (1, 2; 18) having one face (1a; 18a) exposed to the incident light (7) from the sun, **characterized in that** it comprises, in the path of the incident rays, light-polarizing means (3), followed by reflecting means (4) suitable for reflecting toward said exposed face (1a; 18a) all or some of the polarized light (8) and in imparting thereto a modified polarization so that the reflected light (9) is absorbed by said polarizing means (3) and gives rise to heating of said glazed wall (1; 18).

2. Device according to Claim 1, **characterized in that** said polarizing means (3) are chosen in order to polarize the incident light (7) in a circular (levorotatory or dextrorotatory), elliptical or rectilinear manner and/or possess a circular birefringence property, and **in that** the reflecting means (4) are chosen to reverse the polarization of the polarized light (8) transmitted by the polarizing means (3).

3. Device according to Claim 1 or Claim 2, **characterized in that** the reflecting means (4) are chosen so as to reflect only one portion of the spectrum of light wavelengths received.

4. Device according to Claim 3, **characterized in that** said reflecting means (4) are chosen to reflect only all or some of the infrared component of the polarized light received and let through all or some (10) of the visible component of the polarized light received.

5. Device according to any one of the preceding claims, **characterized in that** the polarizing means (3) for polarizing the incident light (7) consist of a polarizing filter positioned on the exposed face (18a) of the glazed wall (18), or integrated into the bulk of the glazed wall (18).

6. Device according to any one of the preceding claims, **characterized in that** the means (4) for reflecting the polarized light (8) consist of a reflecting filter affixed to the rear face (18b) of the glazed wall (18), or integrated into the bulk of the glazed wall (18).

7. Device according to any one of the preceding claims, **characterized in that** said polarizing means (3) and said reflecting means (4) are integrated into a single glass pane (18) intended to be heated under the effect of the absorption of the infrared radiation received from the reflecting means (4) and that transmits the heat absorbed to at least one air space (5B, 6B) delimited by at least one transparent glass pane (16, 17).

8. Device according to any one of Claims 1 to 6, **characterized in that** said polarizing means (3) are integrated into a first glass pane (1), and **in that** said reflecting means (4) are integrated into a second glass pane (2) placed behind said first glass pane (1) in the path of the incident light rays, said first glass pane (1) being caused to heat up under the effect of the absorption of the infrared radiation received from the reflecting means (4).

9. Device according to Claim 8, **characterized in that** said first glass pane (1) and said second glass pane (2) are separated by an air space (5, 6) caused to heat up in contact with said first glass pane (1).

10. Device according to Claim 8, **characterized in that** said first glass pane (1) and said second glass pane (2) are fastened together and in thermal contact with one another so as to heat up together under the effect of the absorption of the infrared radiation by said first glass pane (1), and **in that** the heat thus produced is transmitted to at least one air space (5A, 6A) delimited on one side by the first and/or the second glass pane (1, 2) and on the other side by at least one transparent glass pane (16, 17).

11. Device according to any one of the preceding claims, **characterized in that** the sole glass pane (18) or the first glass pane (1) and/or the second glass pane (2) is made of organic glass or made of crystalline glass.

12. Device according to any one of the preceding claims, **characterized in that** said polarizing means (3) and said reflecting means (4) are produced by a surface treatment or a bulk treatment of the glazed walls (1, 2; 18).

13. Device according to any one of the preceding claims, **characterized in that** the reflecting means (4) are formed from metallic particles taken from aluminum, copper, nickel, cobalt, titanium, silver, gold and platinum.

14. Device according to any one of the preceding claims, **characterized in that** the sole glass pane (18) or the first (1) and/or the second glazed wall (2) reflects or absorbs ultraviolet radiation.

15. Device according to any one of the preceding claims, **characterized in that** the sole glass pane (18) or the first (1) and/or the second glazed wall (2) is semi-transparent and/or colored.

16. Device according to any one of the preceding claims, **characterized in that** said polarizing means (3) and/or said reflecting means (4) are integrated into flexible and optionally selfadhesive films.

17. Device according to any one of the preceding claims, **characterized in that** the air space (5, 6; 5A, 6A) adjoining the glazed walls (18; 1, 2) is replaced by another gaseous, liquid or solid transparent fluid, or by a phase change material or by a vacuum.

18. Device according to any one of the preceding claims, **characterized in that** it comprises an optic of concave mirror, lens, prism, Fresnel lens or heliostat type, for concentrating the incident solar light (7) toward the exposed face (1a; 18a) of the device, or in order to concentrate the light (10) transmitted by the device.

19. Device according to any one of the preceding claims, **characterized in that** it comprises photovoltaic cells positioned over a portion of the surface of the glazed walls (18; 1, 2) and/or of the transparent glass panes (16, 17) so that a portion of the incident solar radiation (7) or of the transmitted radiation (10) shines on said cells and is converted into electricity, while another portion of the incident solar radiation (7) is converted into heat.

20. Device according to Claim 19, **characterized in that** said photovoltaic cells are positioned in parallel strips spaced out by transparent strips, the width of which is less than 1 micron, so that said photovoltaic cells carry out both the role of rectilinear polarization of the incident solar radiation and the role of producing electricity.

21. Device according to any one of the preceding claims, **characterized in that** it is equipped with a mechanical system for ensuring the circulation of the gaseous or liquid fluids between and/or around the glazed walls (18; 1, 2).

22. Device for collecting solar energy according to any one of the preceding claims, **characterized in that** it comprises a solid or flexible frame or support made of metal, wood or composite materials that is capable of adapting the collecting device to windows, sliding bay windows, greenhouse walls, swimming pool covers, garden sheds, aircraft windows, skylights, transport vehicle windows, billboards, shop windows, tiles, roofs, and to all devices that use transparent materials in the fields of construction, transport vehicles, bill posting and broadcasting of images, including electronic display screens.
